# EUROPÄISCHE PATENTSCHRIFT

(11) **EP 1 088 238 B1**
(45) Veröffentlichungstag und Bekanntmachung des Hinweises auf die Patenterteilung: **25.02.2004**
(21) Anmeldenummer: 00917045.7
(22) Anmeldetag: 05.04.2000
(51) Int. Cl.: G01R 1/04

(54) **ADAPTERSOCKEL ZUR AUFNAHME VON ELEKTRONISCHEN TESTOBJEKTEN**
ADAPTER BASE FOR RECEIVING ELECTRONIC TEST OBJECTS
SOCLE ADAPTATEUR DESTINE A RECEVOIR DES OBJETS ELECTRONIQUES A TESTER

(30) Priorität: 16.04.1999 DE 29906730 U
(43) Veröffentlichungstag der Anmeldung: 04.04.2001
(73) Patentinhaber: IsarTec GmbH, 84036 Landshut (DE)
(72) Erfinder: Gesch, Helmuth, 81184 Tiefenbach (DE); Waidelich, Markus, 80639 München (DE)
(74) Vertreter: Gustorf, Gerhard, Dipl.-Ing.
(86) Internationale Anmeldenummer: PCT/EP2000/002995
(87) Internationale Veröffentlichungsnummer: WO 2000/063706

(56) Entgegenhaltungen:
- WO-A-93/04512
- GB-A- 2 104 669
- US-A- 5 289 118
- US-A- 5 519 331
- PATENT ABSTRACTS OF JAPAN vol. 009, no. 054 (P-340), 8. März 1985 (1985-03-08) & JP 59 192981 A (MITSUBISHI DENKI KK), 1. November 1984 (1984-11-01)
- PATENT ABSTRACTS OF JAPAN vol. 1999, no. 04, 30. April 1999 (1999-04-30) & JP 11 023655 A (ANDO ELECTRIC CO LTD), 29. Januar 1999 (1999-01-29)

## Beschreibung

Die Erfindung betrifft einen Adaptersockel zur Aufnahme von elektronischen Testobjekten (DUT = device under test), der eine äußere Gruppe (Array) von Kontaktstiften aufweist, die von seiner Oberseite zur Unterseite durchgeführt sind, sowie eine innere Matrix von nur an der Unterseite herausgeführten Kontakten, denen auf der Oberseite ein von Beschaltung freier Bereich entspricht.

Zum Testen von Objekten, insbesondere von kompakten elektronischen Bauelementen mit einer Vielzahl von Anschlüssen, ist es bekannt, diese auf einem Nullkraftsockel (ZIF = Zero Insertion Force) festzuklemmen, welcher mit seinen an der Unterseite vorstehenden Kontakten fest mit einer Platine verbunden ist. Die Schwierigkeit besteht darin, daß die Konfiguration des zu testenden Objekts innerhalb einer Baureihe oder von Hersteller zu Hersteller variiert, so daß es nur mit Mühe und großem Zeitaufwand möglich ist, die zu testende integrierte Schaltung den Erfordernissen entsprechend zu verschalten. Nur mit einer individuell hergestellten Übergangsschaltung können elektrische Signale und Versorgungsspannungen den einzelnen Kontakten richtig zugewiesen werden.

Ein dem Oberbegriff des Patentanspruchs 1 entsprechender Adaptersockel ist aus US-A 5 519 331 bekannt. Bei diesem muß jedoch für jedes zu testende Objekt die Adapterplatine individuell hergestellt werden, da das Board-Layout mechanisch festgelegt ist und keine Umsteuerung der Kontaktstifte erlaubt.

Gegenstand der US-A 5 289 118 ist eine Testvorrichtung für integrierte Schaltungen mit der Möglichkeit, über ein Bypass-Signal eine Umschaltung von Strom- auf Spannungsquelle vorzunehmen. Zur Stabilisierung der Spannungsversorgung dienen fest verdrahtete Kondensatoren. Zum vorbekannten Stand der Technik ist eine Bypass-Schaltung mit einem Feldeffekttransistor erläutert, der über einen Schalter betätigt werden kann, um die Verbindung zu einer Spannungsquelle oder zu Masse herzustellen.

Der Erfindung liegt die Aufgabe zugrunde, einen Adaptersockel zur Aufnahme von elektronischen Testobjekten zur Verfügung zu stellen, der innerhalb kürzester Zeit bei allen Kontaktstiften gleichzeitig den elektrischen Kontakt der zu testenden integrierten Schaltung feststellt und eine automatische Schaltung an den Kontaktstifte entsprechend dem zu testenden Objekt vornimmt, und zwar in Abhängigkeit davon, ob die Kontaktstifte elektronische Signale übertragen sollen oder als Versorgungskontakte dienen.

Bei einem Adaptersockel der eingangs erläuterten Bauweise wird diese Aufgabe erfindungsgemäß durch die im kennzeichnenden Teil des Patentanspruchs 1 angegebenen Merkmale gelöst.

Dadurch, daß jeder Kontaktstift mit zusätzlichen elektronischen Komponenten (Schalttransistor und Kondensator) verbunden ist, ergibt sich die Möglichkeit, je nach dem geforderten Betriebsmodus des Kontaktstiftes Signale zu übertragen oder den Kontaktstift an Betriebsspannung oder Masse anzulegen. Mittels eines Steuersignals, das von einem Steuergerät, z. B. Computer oder PC, geliefert wird, wird das Gate des Schalttransistors geöffnet oder geschlossen, so daß der Kondensator bei Bedarf zugeschaltet wird.

Es ist von Vorteil, wenn zwei Kondensatoren unterschiedlicher Kapazitäten vorgesehen sind.

In Weiterbildung der Erfindung sind die Kontaktstifte als Federpins ausgebildet, die eine sichere Verbindung zwischen den Lötaugen der das zu testende Bauteil aufnehmenden Platine und den Kontakten des Adaptersockels gewährleisten.

Wenn der Adaptersockel einen mehrlagigen Hybridaufbau hat, ist eine hochkompakte Bauweise möglich, die es erlaubt, im Sockel eine Vielzahl von Bauteilen unterzubringen. So ist es etwa möglich, in mehreren Lagen beispielsweise 225 Transistoren und 500 Kondensatoren unterzubringen.

Die Erfindung ist nachstehend an einem Ausführungsbeispiel erläutert, das in der Zeichnung dargestellt ist. Es zeigen:
Figur 1 in schematischer Ansicht einen Adaptersockel gemäß der Erfindung zum Testen eines Objektes,
Figur 2 die Oberseite des Adaptersockels der Figur 1,
Figur 3 die Unterseite des Adaptersockels und
Figur 4 die Beschaltung eines Kontaktstiftes (Federpin) gemäß der Erfindung.

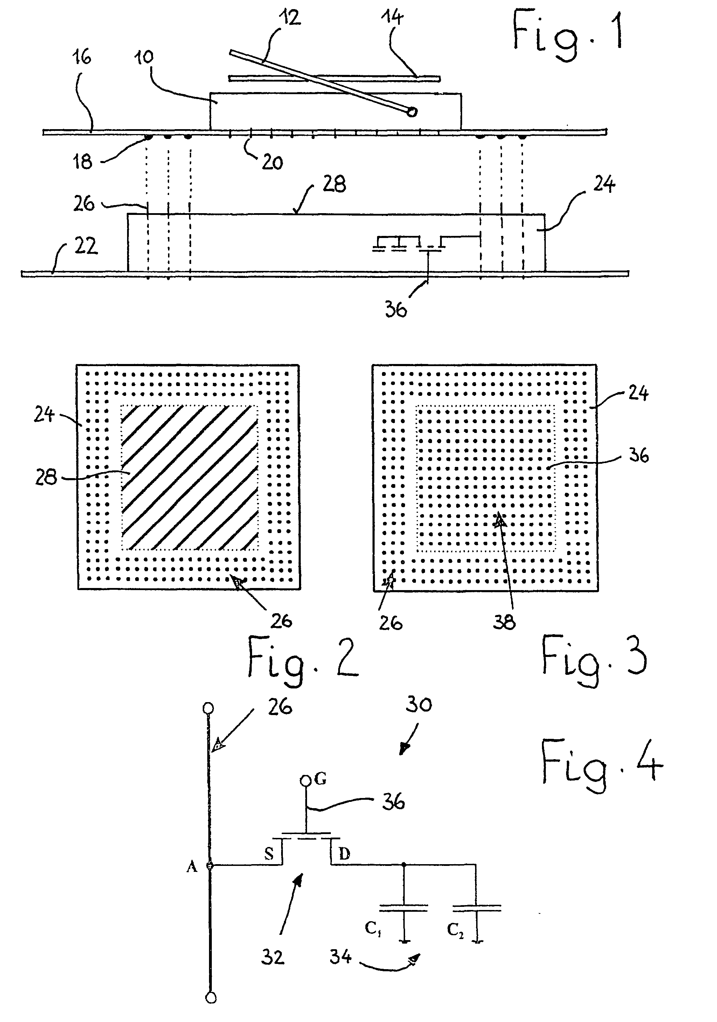

Figur 1 zeigt die schematische Seitenansicht eines Nullkraftsockels 10 (ZIF-Sockel), auf dessen Oberseite über einen Klemmbügel 12 das Testobjekt 14 (DUT = device under test) fixiert werden kann. Der Nullkraftsockel 10 ist auf einer Platine 16 befestigt, die auf ihrer Unterseite eine äußere Gruppe (Array) von Lötaugen 18 hat, von denen jedes in nicht dargestellter Weise mit einem Anschluß 20 an der Unterseite des Nullkraftsockels 10 verbunden ist.

Auf einer weiteren Platine 22 ist der Adaptersockel 24 gemäß der Erfindung angebracht. Dieser hat eine in Figur 2 erkennbare, äußere Gruppe (Array) von Kontaktstiften 26, die als Federpins von der Oberseite zur Unterseite des Adaptersockels 24 durchgeführt sind. Die Konfiguration dieses Arrays der Kontaktstifte 26 entspricht exakt dem Array der Lötaugen 18 der das Testobjekt 14 aufnehmenden Platine 16. Im vorliegenden Fall ist der Adaptersockel 24 quadratisch ausgebildet, wobei der Array der Kontaktstifte 26 an allen vier Rändern ausgebildet ist, während der schraffiert dargestellte, quadratische mittlere Bereich 28 von Beschaltung frei ist.

Gemäß der Erfindung ist nun vorgesehen, daß entsprechend der schematischen Darstellung der Figuren 1 und 4 jeder Kontaktstift 26 im Adaptersockel 24 mit einer Reihenschaltung 30 aus zusätzlichen elektronischen Komponenten verbunden ist, bestehend aus einem Schalttransistor 32 und zwei Kondensatoren C₁ und C₂.

Der Anschlußkontakt 36 des Gates G des Schalttransistors 32 ist aus der Unterseite des Adaptersockels 24 herausgeführt und bildet mit den anderen Gate-Anschlüssen 36 eine innere Matrix 38 aus Kontakten, die dem auf der Oberseite des Adaptersockels 24 vorgesehenen, von Beschaltung freien Bereich 28 entspricht.

In Abhängigkeit von der elektrischen Ansteuerung der Kontaktstifte 26 können diese digitale oder analoge Signale übertragen oder als Versorgungsanschluß für Betriebsspannung geschaltet werden. Wenn nämlich ein Kontaktstift 26 Versorgungsspannung führt, erhält das entsprechende Gate G des zugeordneten Schalttransistors 32 Steuerspannung, so daß dieser geschlossen wird und die beiden Kondensatoren 34 niederohmig an den Kontaktstift 26 angebunden sind. Wenn umgekehrt über den Kontaktstift 26 ein Signal übertragen wird, beispielsweise mit Frequenzen bis zu 100 MHz, bleibt das Gate G des Schalttransistors 32 offen, so daß die Kondensatoren 34 nicht zugeschaltet werden.

Die Ansteuerung der Schalttransistoren 32 erfolgt mittels Steuersignalen, die von einem Steuergerät geliefert werden, beispielsweise einem Computer oder einem PC.

Wie bereits erwähnt, kann der Adaptersockel 24 gemäß der Erfindung eine Mehrschicht-Hybridaufbau in Keramikbauweise haben, so daß eine Vielzahl von Bauteilen untergebracht werden kann. Im dargestellten Ausführungsbeispiel der Figuren 2 und 3 sind drei Schichten vorgesehen, von denen eine 225 Transistoren 32 aufnimmt, während in zwei weiteren Schichten jeweils 550 Kondensatoren 34 untergebracht sind.

## Patentansprüche

1. Adaptersockel zur Aufnahme von elektronischen Testobjekten (DUT), der eine äußere Gruppe (Array) von Kontaktstiften (26) aufweist, die von seiner Oberseite zur Unterseite durchgeführt sind, sowie eine innere Matrix (38) von nur an der Unterseite herausgeführten Kontakten (36), denen auf der Oberseite ein von Beschaltung freier Bereich (28) entspricht, **dadurch gekennzeichnet, daß** jeder Kontaktstift (26) mit einer im Adapter sockel (24) ausgebildeten Reihenschaltung (30) aus einem Schalttransistor (32) und wenigstens einem nachgeordneten Kondensator (34) verbunden ist, wobei die Anschlubkontakte (36) der gates (G) der Schalttransistoren (32) die innere Matrix (38) an der Unterseite des Adaptersockels (24) bilden und die Kondensatoren (34) über ein Steuersignal an das gate (G) zu und abschaltbar sind, derart, daß jedem Kontaktstift (26) über das Steuersignal alternativ Versorgungsspannung oder ein elektronisches Signal zugeordnet werden kann.

2. Adaptersockel nach Anspruch 1, **dadurch gekennzeichnet, daß** zwei Kondensatoren (34) unterschiedlicher Kapazitäten vorgesehen sind.

3. Adaptersockel nach Anspruch 1 oder 2, **dadurch gekennzeichnet, daß** die Kontaktstifte (26) als Federpins ausgebildet sind.

4. Adaptersockel nach einem der Ansprüche 1 bis 3, **gekennzeichnet durch** einen mehrlagigen, kompakten Hybridaufbau.

## Claims

1. Adapter base for mounting electronic devices under test (DUT), comprising an outer group (array) of pins (26) extending through it from its upper surface to its lower surface, and an inner matrix (38) of contacts (36) extending only from its lower surface to which inner matrix corresponds an area (28) on the upper surface which is free of wiring, **characterized in that** each pin (26) is connected to a series arrangement (30) inside the adapter base (24) of a switching transistor (32) and at least one downstream capacitor (34), wherein the connecting contacts (36) of the gates (G) of the switching transistors (32) constitute said inner matrix (38) on the lower surface of the adapter base (24) and wherein said capacitors (34) may be switched in or switched off by means of a control signal to said gate (G) such that via said control signal to each pin (26) may be alternatively allocated a supply voltage or an electronic signal.

2. Adapter base according to claim 1, wherein two capacitors (34) of different capacitance are provided.

3. Adapter base according to claim 1 or 2, wherein said pins (26) are spring pins.

4. Adapter base according to anyone of claims 1 to 3, **characterized by** a compact multilayer hybrid structure.

## Revendications

1. Socle adaptateur destiné à recevoir des composants électroniques à tester (DUT), comprenant un groupe extérieur (array) de broches de contact (26) traversant le socle de la surface supérieure à la surface inférieure, et une matrice intérieure (38) de contacts (36) disposés seulement sur la surface inférieure et auxquels correspond à la surface supérieure une zone (28) libre de connexions, **caractérisé par le fait que** chaque broche de contact (26) est reliée à un circuit en série (30) d'un transistor de commutation (32) et d'au moins un condensateur (32) placé en aval, les contacts de raccordement (36) des grilles (G) des transistors de commutation (32) formant la matrice intérieure (38) sur la surface inférieure du socle adaptateur (24), les condensateurs (34) étant aptes à être mis en circuit et hors circuit de sorte qu' à chaque broche de contact (26) puisse être appliqué alternativement, par un signal de commande, une tension d'alimentation ou un signal électronique.

2. Socle adaptateur selon la revendication 1, **caractérisé par le fait qu'**il y a deux condensateurs (34) de capacités différentes.

3. Socle adaptateur selon la revendication 1 ou 2, **caractérisé par le fait que** les broches de contact (26) sont des broches faisant ressort.

4. Socle adaptateur selon une des revendications 1 à 3, **caractérisé par** une structure hybride compacte à plusieurs couches.
